Europäisches Patentamt

European Patent Office

Office européen des brevets

(11) Publication number: **0 066 339**
**A2**

# EUROPEAN PATENT APPLICATION

(21) Application number: 82200627.6

(51) Int. Cl.³: **H 05 K 13/00**

(22) Date of filing: 24.05.82

(30) Priority: 22.05.81 US 266564
10.05.82 US 376887

(43) Date of publication of application:
08.12.82 Bulletin 82/49

(84) Designated Contracting States:
DE FR GB IT

(71) Applicant: North American Philips Corporation
100 East 42nd Street 9th Floor
New York, N.Y. 10017(US)

(72) Inventor: Johnson, Carl William
c/o INT. OCTROOIBUREAU B.V. Prof. Holstlaan 6
NL-5656 AA Eindhoven(NL)

(74) Representative: Hartung, Edgar Erwin et al,
INTERNATIONAAL OCTROOIBUREAU B.V. Prof.
Holstlaan 6
NL-5656 AA Eindhoven(NL)

(54) Polyfoam chip carrier tape.

(57) A flexible, engineered, laminated polyfoam component carrier tape having a stable base layer member, a flexible expandable and compressible upper member layer, said two layers having appropriate sprocket holes and chip cavities formed therein, a bottom cover layer providing a base for said chip cavities, said bottom cover layer being heat sealable to the rigid base layer, and a controlled, creped thermally bonded and peelable top cover layer to retain the chip components in said tape until such time as they are presented to automatic placement equipment. The sprocket holes provide drive engagement integrally formed in said tape. Spaced recessed areas are formed in the carrier tape for receiving chip components. The use of one or more transparent plastic films on either the top or bottom cover layer provides optical verification of the presence or absence of components in each of the recessed areas after the carrier tape is loaded with components.

FIG.1

EP 0 066 339 A2

Croydon Printing Company Ltd

0066339

"Polyfoam chip carrier tape".

The invention pertains to a polyfoam chip carrier tape for leadless electronic and electrical components for use with automatic component placement machines. In particular, it is directed to a flexible low cost carrier tape that can be adapted to high speed packaging and placement of leadless components, frequently referred to in the art as chip components and/or surface mounted devices. Leadless components include chip capacitors, chip resistors, chip transistors and chip integrated circuits in general rectangular configuration and, where applicable, cylindrical components, specifically capacitors and resistors, jumpers, mini-mold transistors, diodes and other components not specifically mentioned. In contemporary usage, leadless components are currently also designated as surface mounted devices.

Description of the Prior Art

With the extensive use of leadless devices, surface mounted devices and/or chip components, several methods of chip packaging have been developed for use with automatic placement equipment. Cassette type packages are well known in the prior art and their limitations are also well known, especially in the area of high speed placement. Taping systems for electrical components are also well known in the prior art. U.S. Patent 2,372,072 pertains to a system for packaging coiled filaments for electric lamps. This system includes a carrier tape, a reel and the construction of the tape itself.

Tapes which are designed to hold objects, whether these objects be leadless electrical components, medicinal dosages or other small size objects are also relatively well known in the prior art. In order to package such small articles for delivery to the user, whether the user be a person who simply removes the objects singly from the package or a machine which automatically removes the objects at high speed for further handling, usually involves a laminated tape of some sort having a cavity or a recess therein. The tape serves as a carrier, the cavity serves as a location for the object to be packaged and a cover is usually laminated to the carrier tape to hold the object in place until it is to be used. The prior art in laminated carrier tapes is rather extensive. British Patent No. 1,401,991 discloses a dispensing means in the form of a coiled web having provision to hold articles of various materials in separate cavities. The web may be flexible or rigid and of indeterminate length. The invention was directed to dispensing packages such that the packaged objects may be dispensed by the unwinding of a coiled web. The invention was adapted to storing and dispensing small articles, in particular, small medical articles such as sutures and/or dosages of medicines. A related British Patent No. 1,401,992 discloses the use of the same package for electrical components such as transistors and includes the use of compressible materials of various densities. In these related British patents, the various layers of the carrier tape are held together by adhesives.

More recently U.S. Patent 4,298,120 has issued, disclosing a range of ideas for chip carrier tape. Since this U.S. patent is totally devoid of an enabling disclosure and/or a best mode, its value as prior art is restricted to suggestions of ideas.

European patent application 0,013,979 simply mentions a chip carrier tape and again lacks any enabling disclosure for such a tape.

A variety of chip carrier tapes are currently available commercially. The prior art, as it has evolved into commercial products, presents to the manufacturer and user of leadless components several problems to which the present invention is directed. Among these problems are the cost of taping leadless or chip components, the cost of packaging the tapes of components and the delivery systems for feeding a plurality of reels to automatic placement equipment. In terms of costs, the manufacturers of chip components find that the cost of taping these components including the reels and protective containers for the reels of tape, is currently four to ten times the desirable goal.

Since a carrier tape is designed to hold chip components, it will have a certain thickness which will slightly exceed the thickness of the chips themselves. In the prior art, the thick portion of a carrier tape which, under the proposed standard, ranges from .94 mm to 1.75 mm in thickness, was traditionally made of a cardboard, chip board or similar substance which could be wound on reels. The carrier tape further included a cover tape on its bottom and a cover tape on its top, the function of the cover tapes being to retain the components in position in the cavities on the carrier tape. A major problem with the carrier tape of the prior art and the carrier tape presently commercially available is that the tape has an inherent tendency to unwind from a reel and return to a linear position rather than a circular position, better known as the clock spring effect. The reason for this tendency is obvious. When wound on a reel the bottom of the tape has a tendency to be in compression whereas the top of the tape has a tendency to be in tension. Given the relatively rigid materials from which the tapes were made, the winding of the tape induced two effects, a clock spring effect whereby the tape has a tendency to unwind and to return to a normal linear position and a delamination of the top and bottom cover tapes which resist the compression and/or tension forces resulting from being wound on a reel. Of all the existing prior patented art, only the British patents cited above have even adressed this problem.

The above-mentioned deficiencies in the prior patent art and the commercially available tape create obvious problems for the use of taped components. The rolled tapes on reels tend to be difficult to handle. A stiff or relatively stiff tape when wound on a reel tends to have a clock spring action when the reel is removed from its package and the user begins to unwind the tape for feeding into a placement machine. This leads to unnecessary time delays and occasional mishandling of reels during loading, thus causing delays in the utilization of automatic placement equipment. Delamination of either of the two cover tapes is also a serious problem because components tend to be missing from cavities where they are expected. The goal of an automatic placement process is to limit failures to less than ten parts per million. Delamination of the cover tapes can cause the failure rate to exceed acceptable tolerances.

The prior art also discloses a plastic embossed tape which is also commercially available.This carrier tape has no bottom tape because of its basic construction. Hence the compression factor is partially absorbed by the component cavities and the tension factor is minimized. A major drawback to the use of this tape is its high cost.

SUMMARY OF THE INVENTION

The carrier tape of the present invention consists of a low cost, disposable, flexible, engineered, laminated, polyfoam carrier tape for packaging chip components (leadless components, surface

mounted devices) and for holding these components in position as the taped chips are fed to automatic placement equipment. After packaging of the chips in the tape the tape is wound on a reel, the laminated polyfoam carrier tape permitting itself to be wound around the core of such a reel without damage to the tape or to the chips held within the tape. The invention also further pertains to a method of constructing the flexible engineered laminated carrier tape and the method of inserting the chips into the tape for packaging and removing the chips from the tape for placement.

The engineered laminated polyfoam carrier tape of the present invention solves the problems which have arisen in the prior art tapes by providing a flexible, engineered, laminated carrier tape with a provision for compensation for the varying tension and compression of the layers of the laminated structure. To achieve this goal, the base layer member of the flexible engineered laminated polyfoam carrier tape of the present invention has to remain a relatively stable, non-stretching member to engage a sprocket drive. This layer is a chemically neutral, electrical grade Kraft paper. The bulk of the carrier tape above the base paper layer is a cross-linked polyethylene foam extruded as a closed cell foam and skived to a desired thickness. The thickness of the foam layer may be varied according to the thickness of the components to be carried in the tape. This polyethylene foam is heat sealed to the base paper layer. No adhesive is used. Sprocket holes and component cavities or recesses are punched in this laminated paper/foam structure. The bottom cover tape, covering only the component cavities, is a laminated, heat-sealable polyester and polyethylene tape. The bottom cover tape is heat-sealed by its polyethylene layer to the base paper layer and has a width which covers only the chip cavities of the carrier tape and does not cover the sprocket holes on carrier tape. The bottom cover layer is a transparent plastic material which permits the visual inspection of a loaded carrier tape. Alternatively, a layer of heat activated coated (such as by polyethylene) aluminium foil could be used.

With respect to the carrier tape, the base layer of the carrier tape, being a strong sheet of Kraft paper, serves as the primary structural member of the laminated tape. With its strong paper base and a compressible foam layer, sufficient structural integrity is provided for the punching of cavities to hold chip components and sprocket holes to accommodate a drive means. Alternate embodiments for this flexible, laminated structure are possible, including laminates of plastic or plastic foams, polycoated papers, aluminium, creped papers and other materials.

After the chips are placed in the cavities of the carrier tape, a flexible, peelable top cover tape is applied to retain the chips in the cavities. In the polyfoam carrier tape of the present invention, the flexible top cover tape is fabricated from a plastic film with a higher melt point then the polyethylene foam of the carrier tape. A preferred material is a polypropylene film. To achieve the desired flexibility in a peelable top cover tape the polypropylene film is fluted or creped by passing it between two creping wheels, one of which is heated, thus providing a controlled rather than a random crepe or random corrugated fluting to the polypropylene film. As the heated tape leaves the creping wheels, it is applied directly to the top of the foam carrier tape which already contains chip components. With moderate pressure, the polypropylene film is sealed to the foam carrier tape where the tips of the fluted plastic film touch the foam tape. The moderate amount of pressure furthermore serves both to secure a bond to the foam and to compress the foam such that the foam does not rise more than the thickness of the corrugated flutes above the upper surface of the chips contained in its cavities. The flute spacing is designed such that the tips are always present to ensure spot seals around all edges of the chip cavities. Since the cover tape only covers the cavities on the carrier tape and not the sprocket holes, the heated creping wheel further contains a smooth hub surface to thermally compress the foam around the sprocket holes to the same thickness as the foam around the cavities. Thus, the thickness of the foam carrier tape is adjusted to the size of the components being carried in the tape in the final step during the sealing of the cover tape. When a reel of polyfoam chip carrier tape containing components is used in an automatic placement machine, the top cover tape will be peeled from the carrier tape to permit the extraction of chips from the carrier tape by automatic chip placement equipment. Hence the top cover tape is sealed in such a fashion that it can be easily clean-peeled without damage to the tape or to the chips and without leaving any fragmentary residue which could cause a blockage in the vacuum pick-up of an automatic chip placement machine. Since the sealing of the cover tape requires no adhesive, the cover tape will not adhere to the chip components even when heat is applied. A creped material is a preferred cover tape for this invention because it provides flexibility without delamination, the polypropylene tape of the preferred embodiment being the most preferred material based on extensive testing. A flexible carrier tape without an elastic peelable top cover tape will not provide any advantages in relieving surface tension.

The flexible, engineered laminated polyfoam carrier tape of the present invention thus provides a carrier tape which can be wound upon reels having a small diameter core without damage to the components and without delamination of the top or bottom cover tapes, since the flexible, engineered, laminated carrier tape has a built-in capability of expansion and compression. The flexibility of the polyfoam chip carrier tape enables the tape to operate well with high speed packaging and placement equipment. In the preferred embodiment, the construction described is a non-adhesive construction, the laminated layers being held together by an application of heat to various plastic materials, followed by immediate cooling. This tape further provides a very low cost construction because it utilizes inexpensive standard materials. The flexibility is maintained by incorporating a creped cover tape and foam in the upper layer of the carrier tape. This construction has a further advantage of providing additional bulk or thickness by the simple technique of skiving the polyfoam to slightly exceed the basic dimensions of the chip components being taped. Hence as the components become thicker, the basic structure does not have to be re-engineered.

Other embodiments of the basic laminated structure can be achieved through variation of the materials used in the layers of this engineered, laminated carrier tape. For instance, a soft elastic plastic rubber, tissue paper, crepe paper, plastic films or a rubber or plastic foam could be substituted for some of the laminations in this carrier tape.

BRIEF DESCRIPTION OF THE DRAWING.

Figure 1 is an enlarged side perspective view of a cut-away segment of the polyfoam chip carrier tape of the present invention.

Figure 2 is a cross-sectional view of the tape of Figure 1.

Figure 3 is a top plan view of the tape of Figure 1.

Figure 4 is a perspective view of the creping wheels which are used in the creping of the cover layer and final sealing of the polyfoam chip carrier tape.

Figure 5 is a front view of the creping and sealing mechanism.

DESCRIPTION OF THE PREFERRED EMBODIMENT.

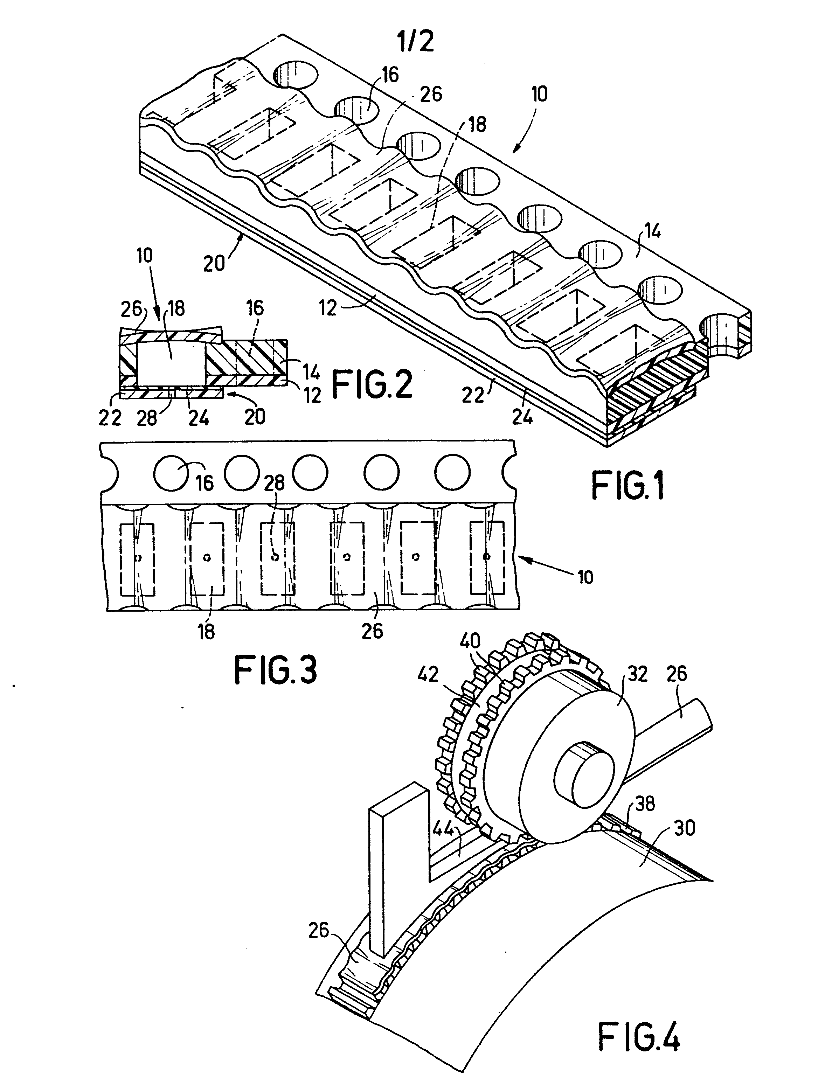

The preferred embodiment will be described with reference to Figures 1, 2 and 3, each of which illustrates most of the features of the invention.

Polyfoam chip carrier tape 10 is a laminated structure which in the preferred embodiment, according to proposed standards, is 8 mm wide, having a relatively strong and stable base layer member 12. Base layer 12 in the preferred embodiment is a chemically neutral, electrical grade Kraft paper having a thickness ranging from .005 in. to .010 in. The second bulk layer 14 of polyfoam chip carrier tape 10 is a high quality, closed cell, cross linked foam polyethylene having a density of two pounds per cubic foot. The polyethylene foam layer 14 when heated from the bottom side becomes slightly tacky on its bottom surface. The base paper layer 12 is laminated to the polyethylene foam layer 14 by an application of heat through the paper followed by cooling. After this lamination, the polyfoam carrier tape now provides the desired tape structure for carrying chip components. Sprocket holes 16 and chip cavities or recesses 18 are then plunched or otherwise formed in polyfoam chip carrier tape 10. Alternatively, the chip cavities 18 could be thermally compressed pockets in the polyfoam layer 14 alone. The base paper layer 12 has to remain a relatively stable, non-stretching member of the laminated polyfoam carrier tape 10 to engage a sprocket drive. The polyfoam layer 14 of the carrier tape 10 is elastic both in compression and in tension, thus minimizing the tension and compression on the base paper member 12 when wrapped around a wheel or core.

The bottom cover tape 20 in the preferred embodiment is a laminated clear transparent plastic layer which, according to said proposed standards is 5.2 mm in width, so that it will not cover sprocket holes 16, the drive engaging means of the chip carrier tape 10. This bottom cover laminated tape has a bottom layer 22 which is a clear transparent temperature resistant polyester film with a clear coating or surface treatment 24 as its upper heat sealable layer. The heat sealable layer 24 is a thin coating of low density polyethylene which is laminated with the high melt point polyester to form a unified heat sealable polyester film. The outer lamination is a temperature resistant polyester and the inner lamination is a film that softens and becomes tacky at approximately 300°F. The bottom covered layer 20 is applied to the base paper member 12 of polyfoam chip carrier tape 10 by the application of heat which causes the polyethylene coating 24 to become tacky and adhere to the base paper layer 12. After cooling, the bottom cover 20 becomes a base for cavities 18, which are spaced recessed areas in tape 10.

After component chips are placed in cavities 18 of polyfoam chip carrier tape 10, a top cover tape 26 which, in the preferred embodiment, is a creped or fluted layer 5.2 mm in width, is placed on top of the cavities in polyfoam chip carrier tape 10. The top cover tape 26 is preferably a substance which will be heat sealable to the top surface of the polyfoam layer 14. In the preferred embodiment, the cover tape is fabricated from a plastic film having a higher melt point than the polyethylene foam of layer 14. A low cost substance which meets this requirement is polypropylene. It is also preferred that the top cover tape be a creped or fluted substance because after heat sealing of the top cover tape followed by a cooling, the top cover 26 will have only the tip of each flute which is a small portion of its lower surface adhering to foam layer 14, but these spot bonded flute tips will substantially surround each individual cavity. In the drawings, only a few flutes could be shown for reasons of clarity. This form of heat sealing a top cover tape differs from the prior art in which the sealing is a continuous bead provided only along the two lengthwise edges of the cavities. Also, no prior art cover tape is creped. The limited adhesion of the creped top cover 26 assists the top cover 26 to be easily peeled from the foam layer 14 without leaving any fragmentary residue which could cause a blockage in the vacuum pickup of an automatic chip placement machine. The top cover tape 26 must be peeled from the tape 10 in order for the chips to be removed by automatic placement equipment.

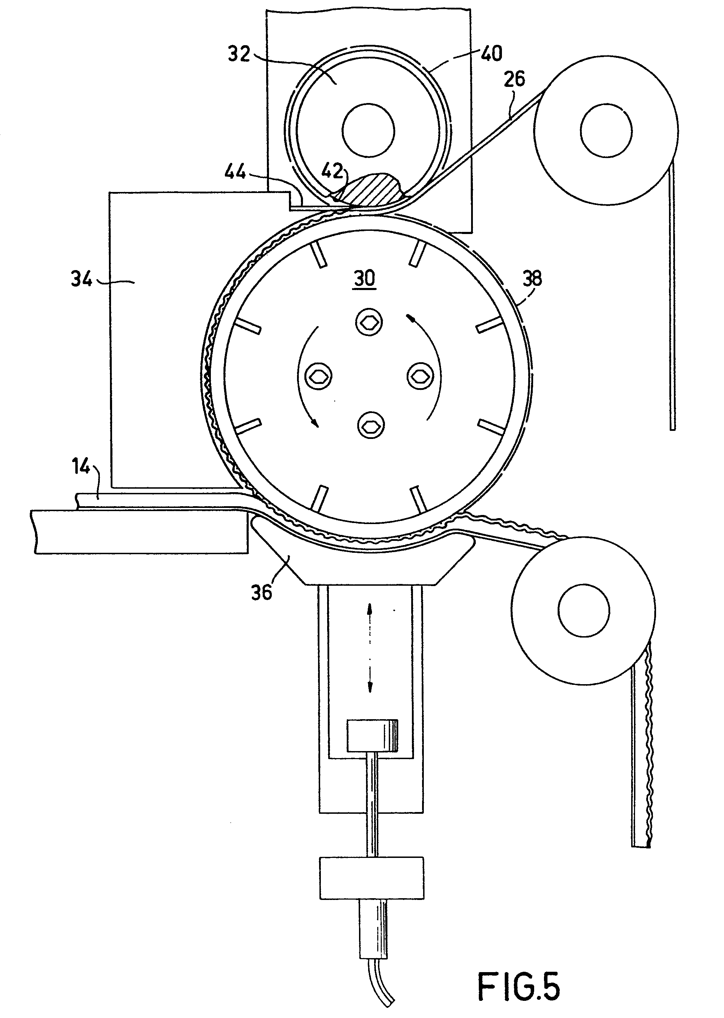

To provide an effective top cover tape 26, it is desired to have a creping or a fluting which is a controlled creping or fluting rather than a random creping or fluting to insure that sufficient flutes on the bottom of the cover tape 26 are available for sealing around the perimeter of each individual cavity. Furthermore, the top cover tape should be creped or fluted crosswise to the machine direction. Figure 4 is an exaggerated perspective view of the creping mechanism used for this purpose. Figure 5 is a front view of the creping and sealing mechanism. Referring now to Figures 4 and 5, in order to achieve this controlled creping, the strip of polypropylene film 5.2 mm in width is passed between heated creping wheel 30 and non-heated creping wheel 32. The non-heated creping wheel 32 has a deep groove 42 through and below the creping teeth 40, located at the midpoint of the width of the wheel. Both creping wheels, 30 and 32 are 5.2 mm in width. The top cover tape creping pressure shoe 34, conforms to the curvature of wheel 30 and gently rubs against the tips of the heated creping teeth 38. The upper most tip of the pressure shoe 34 has a thin, pointed blade 44, which extends into the deep groove 42, below the non-heated creping teeth 40. If the polypropylene film were fed between two creping wheels, the film would not know which wheel to follow and also the creped film would not remain conformed to the creping teeth; it would immediately detach itself from either or both wheels and be loose. Adding pressure shoe 34 to the heated creping wheel 30 holds the creped film within the tooth profile and the pointed blade 44 assures that the creped film follows the heated creping wheel 30 by positive stripping the film away from the non-heated creping wheel 32. The creped polypropylene film is carried around the heated creping wheel 30, under the shoe 34 and is delivered at the bottom of the wheel 30 and emerges out from under the pressure shoe 34. The chip carrier tape 10, containing chips, passes horizontally tangent to the bottom of the heated creping wheel 30, at synchronous surface speed and held in contact with the heated creping wheel by carrier tape pressure shoe 36. Pressure shoe 36 conforms to the curvature of wheel 30 and with pressure applied, bonds the polyethylene foam 14 to the creped polypropylene film 26 which covers and conforms to the heated creping teeth 38. The bond is achieved at the tips of the heated creping teeth 38 only, thus achieving spaced intervals of bonding. A spaced bonding pattern is maintained while the materials are under the heated wheel. The polypropylene film thus heated, creped and sealed makes a durable top cover 26 which can take all the flexures required in high speed production and nevertheless will pull off easily for removal of chips from the polyfoam chip carrier tape.

The present invention also provides an effective means for controlling the thickness of the polyfoam chip carrier tape 10.
Chip components vary widely in thickness. To provide flexibility in
the manufacture of a polyfoam chip carrier tape, the thickness of the
tape can be easily controlled by controlling the thickness of the foam.
The foam is originally made in stock significantly thicker than the
desired thickness of the polyfoam chip carrier tape. The foam is then
skived to a thickness slightly greater than the desired thickness of
the carrier tape 10. A further factor for having the foam slightly
thicker than the desired thickness of the carrier tape is that the
skiving cannot be accurately controlled to the desired tolerance and
some unevenness will result in the skived foam. The application of the
cover tape 26 to the carrier tape 10 provides an opportunity to reduce
the thickness of the carrier tape to the thickness of chips contained
therein. The heated creping wheel 30 which serves to crepe and
seal the top cover tape 26 has a round hub the same diameter as the
root of the heated teeth 38 required to crepe the cover tape 26. As the
carrier tape 10 passes under the heated wheel 30, the cover tape 26 is
creped and heat sealed to foam layer 14 by a slight application of
pressure which will reduce thickness of the carrier tape 10 to the
thickness of the chips contained in its cavities 18. The round hub of
heat wheel 30 will reduce the remaining surface of the foam to the
same desired thickness. Consequently, when polyfoam chip carrier tape
10 emerges as a covered sealed unit, its thickness excluding top and
bottom cover tapes 20 and 26 will be approximately the thickness of
the chips contained within its cavities 18. Hence, polyfoam chip
carrier tape 10 is adaptable to chip components of varying thickness
without a major reengineering of the tape itself or the tooling for
making the tape.

Alternatively, a creped paper may be used as the top
cover layer. However, it has been found more practical and efficient
to use the polypropylene film described in the above paragraphs
which is not precreped, but receives a controlled creping as part of
the sealing process. The technique of thermal compression of the foam
to the desired thickness when bonding the creped cover 26 to foam
layer 14 is the most efficient manufacturing technique discovered by
the inventor. Depending of the materials involved, the temperatures,
pressures and contoured surfaces of the shoe which presses the foam
up against the hot creping wheel during the cover tape application may be easily varied. It is not necessary to put any relief in the toothed creping wheel 30 for clearance around the chips. The process for manufacture of polyfoam chip carrier tape 10 literally prints the creped top cover tape 26 against the top surface of the chips held within cavities 18 of carrier tape 10. Top cover tape 26 will not adhere to the chips because it has no adhesives, even when heated. All prior art top cover tapes have used heat activated adhesives to bond the carrier tape. This has presented a serious problem. If a chip is touched when the tape is hot, the chip will adhere to the cover tape. This cannot be detected until the cover tape is peeled away. The chip peels away with the top cover tape. With this technique, the overall thickness of the tape will always be slightly thicker than the chip itself. This thickness is controlled by the tips of the teeth of the creping wheel 30 while contacting the chips, the chips themselves become the limit in thermally compressing the foam layer 14. In practice, the polyfoam chip carrier tape is approximately .005 in. thicker than the chip thickness. With this minimum thickness, a polyfoam chip carrier tape having approximately 4,000 chips (chips no thicker than .040) can be wound on a 7 in. diameter reel.

For use of the polyfoam chip carrier tape 10 on a high speed packaging machine, it is convenient for the cavities 18 of carrier tape 10 to have a small hole through the bottom cover tape 20 in each cavity 18. This hole 28, shown only in Figures 2 and 3, is for use with a vacuum source to facilitate the high speed loading of chips into the tape cavities 18, even with the tape upside down, and also to hold the chips in the open tape before the creped top cover tape 26 is applied. The most efficient way to achieve the vacuum hole 28 is to pierce the bottom cover tape 26 with sharp needles that puncture through from the cavity side of the chip carrier tape 10. It is also important that the bottom inside surface of each cavity be smooth so as to enable a vacuum to firmly hold a chip. Any frayed edges around the vacuum hole must be on the outside bottom surface of each chip cavity 18. A heated needle forms a clean hole and is preferred. A pair of synchronized rolls (not shown), can be used to make the vacuum holes. The top roll will be heated and is used to heat the needles. The bottom roll has the sprocket teeth pins.

In summary, the laminated polyfoam chip carrier tape 10 of the present invention is a flexible laminated material. The top bulky material 14 is constructed of a closed cell, cross linked, polyethylene foam with an average density of two pounds per cubic foot. The bottom layer 12 is a strong, plain electrical grade paper (with no coatings) which is chemically neutral. The lamination is achieved by applying heat through the paper 12 and achieving a surface melt of the polyethylene foam 14 which then adheres the paper to the foam.

The bottom cover tape 20 is a clear plastic film which is laminated with a thermal melting film. The preferred material is a laminated film, one layer 22 of a high melt point polyester film and the other layer of a low density polyethylene 24. When heat is applied through the polyester film, the polyethylene softens and adheres to the plain paper 12 on the bottom side of the chip carrier tape 10.

The top cover tape 26 is a thin film of polypropylene, creped or fluted on the packaging machine with a heated, toothed, creping wheel 30. The tip of each tooth transfers heat through the polypropylene film and onto the surface of the polyfoam 14. The temperature of the heated tip is sufficient to soften the surface of the polyfoam 14 and adhere it to the film at the tip only. The creped polypropylene film can be gently peeled off the polyfoam to expose the chips for placement. Some alternative constructions are possible. The top cover tape could be a thin, plain paper which is chemically neutral or aluminum foil. It would also be creped in the packaging machine with the same heated toothed creping wheel 30. The bottom cover tape could be a plain aluminum foil if the paper bottom layer of the chip carrier tape was coated with a thermal melting material such as polyethylene film. Aluminum foil makes an excellent material to ground out static electricity that might damage some types of chips.

**0066339**

1. A low cost, disposable, flexible engineered laminated polyfoam carrier tape for packaging leadless components for feeding said components to automatic component placement machines comprising:

a stable base layer member of said laminated tape;

at least one flexible, expandable and compressible upper member layer of said laminated tape;

means to laminate said base layer and upper layer members to form a laminated tape structure;

drive engaging means integrally formed in said laminated tape; and

spaced recessed areas provided in said tape for receiving leadless components.

2. The laminated polyfoam carrier tape of Claim 1, wherein said stable base layer is a sheet of strong chemically neutral paper and said drive engaging means are spaced sprocket holes.

3. The laminated polyfoam carrier tape of Claim 1, wherein:

said flexible, expandable, and compressible member is a closed cell, cross-linked foam polyethylene; and

said foam is laminated to said base member layer by thermal bonding.

4. The laminated polyfoam carrier tape of Claim 3, wherein said spaced recesses are formed in said foam only.

5. The laminated polyfoam carrier tape of Claim 4, wherein:

each of said spaced recesses has a length and a width slightly less than the length and width of the components to be held therein and

said components are forced fitted into said recesses and retained therein by the resiliency of said foam.

6. The laminated polyfoam carrier tape of Claim 1, further comprising:

a flexible, expandable and compressible top cover tape dimensioned to cover the open tops of said spaced recesses without obstructing said tape drive engaging means, said top cover tape removably secured to said upper member layer.

7.        The laminated polyfoam carrier tape of Claim 6, wherein said top cover tape is a creped polypropylene film and said top cover tape is peelably laminated and secured to said upper member layer by thermal bonding.

8.        The laminated polyfoam carrier tape of Claim 1, wherein: said spaced recesses are holes formed in said upper member layer and said base member layer; and further comprising: a bottom cover tape secured to said base member layer; said bottom cover tape covering the base of each of said spaced recesses without obstructing said drive engaging means.

9.        The laminated polyfoam carrier tape of Claim 8, wherein said bottom cover tape is transparent.

10.        The laminated polyfoam carrier tape of Claim 9, wherein said bottom cover tape is a laminated clear plastic film , one of said layers being a thin heat softened plastic film.

11.        The laminated polyfoam carrier tape of Claim 10, wherein said laminated clear plastic bottom cover tape is a lamination of a temperature resistant plastic film and lowermelt temperature plastic film.

12.        The laminated polyfoam carrier tape of Claim 11, wherein each of said spaced recesses has a small hole formed through said bottom cover tape for use with a vacuum source.

13.        The laminated polyfoam carrier tape of Claim 1, further including: a flexible, expandable and compressible top cover tape dimensioned to fit over said spaced recesses without obstructing said drive engaging means; said top cover tape being peelable from said upper member layer such that it may be peeled therefrom to yield access to said components by an automatic component placement machine without leaving a fragmentary residue; means to secure said top cover tape to said upper member layer.

14.        A flexible, expandable and compressible removable top cover tape for a polyfoam carrier tape for holding leadless electronic components in spaced cavities comprising:

a creped thin material randomly spot adhered around the periphery of the spaced component cavities.

15.     The top cover tape of claim 14 wherein said creped material is polypropylene film.

16.     The top cover tape of claim 15 wherein said top cover tape is adhered to said carrier tape by thermal bonding.

17.     The top cover tape of claim 16 wherein said top cover tape is adhered to said polyfoam by thermal bonding the lower tip of each flute of said creped polypropylene film such that small portion of the surface of said cover tape is peelably adhered to said polyfoam carrier tape.

18.     The top cover tape of claim 14 wherein said creped material is paper.

19.     The laminated polyfoam carrier tape of Claim 1, further including:

means permitting the inspection of said recessed areas to determine the presence or absence of components in each of said recessed areas after said tape is loaded with components.

FIG.1

FIG.2

FIG.3

FIG.4

0066339

FIG.5